# EUROPÄISCHE PATENTSCHRIFT

(11) **EP 0 840 995 B1**
(45) Veröffentlichungstag und Bekanntmachung des Hinweises auf die Patenterteilung: **31.03.1999**
(21) Anmeldenummer: 96924826.9
(22) Anmeldetag: 01.07.1996
(51) Int. Cl.: H05K 9/00, H02B 1/16

(54) **SCHALTSCHRANK MIT RAHMENGESTELL UND VERKLEIDUNGSELEMENTEN**
SWITCHGEAR CUBICLE WITH FRAME AND CLADDING
ARMOIRE ELECTRIQUE CONSTITUEE D'UNE STRUCTURE ET D'ELEMENTS D'HABILLAGE

(30) Priorität: 15.07.1995 DE 19525879; 28.10.1995 DE 19540300
(43) Veröffentlichungstag der Anmeldung: 13.05.1998
(73) Patentinhaber: Rittal-Werk Rudolf Loh GmbH & Co. KG, 35745 Herborn (DE)
(72) Erfinder: MÜNCH, Udo, D-35764 Sinn (DE); NEUHOF, Markus, D-35630 Ehringshausen-Niederlemp (DE); REUTER, Wolfgang, D-57299 Burbach 5 (DE); ROOT, Paul, D-35080 Bad Endbach (DE)
(74) Vertreter: Jeck, Anton, Dipl.-Ing.
(86) Internationale Anmeldenummer: EP9602861
(87) Internationale Veröffentlichungsnummer: WO9704631

(56) Entgegenhaltungen:
- EP-A- 0 634 550
- DE-U- 8 714 497
- DE-U- 8 903 815
- FR-A- 2 702 314

## Beschreibung

Die Erfindung betrifft einen Schaltschrank mit einem aus einzelnen Rahmenschenkeln zusammengesetzten und/oder aus an Verkleidungselementen abgekanteten Rahmenschenkeln gebildeten Rahmengestell, dessen offene Seiten mit Verkleidungselementen und einer Schranktür verschlossen oder verschließbar sind, bei dem die Rahmenschenkel und die Verkleidungselemente lackiert sind und bei dem die Rahmenschenkel mindestens eine mit einer Reihe von quadratischen oder rechteckförmigen Befestigungsdurchbrüchen versehene Profilseite aufweisen, die senkrecht zum zugekehrten Verkleidungselement ausgerichtet ist.

Ein Schaltschrank dieser Art ist aus der DE 33 44 598 C1 bekannt. Zwischen den lackierten Teilen des Schaltschrankes besteht keine direkte elektrische Verbindung.

Dies ist auch nicht sicher gewährleistet, wenn die Teile miteinander verschraubt sind. Ist diese elektrische Verbindung zwischen den Verkleidungselementen und dem Rahmengestell erforderlich, dann werden diese Teile mittels eines Erdungsbandes elektrisch eindeutig miteinander verbunden. Dazu müssen beide Teile mit entsprechenden Anschlußelementen versehen sein und das Anbringen des Erdungsbandes bedingt einen zusätzlichen, erheblichen Montageaufwand.

Es ist Aufgabe der Erfindung, bei einem Schaltschrank der eingangs erwähnten Art auf einfache Weise auch nachträglich eine eindeutige elektrische Verbindung zwischen einem Verkleidungselement und dem Rahmengestell zu schaffen.

Diese Aufgabe wird nach der Erfindung dadurch gelöst, daß zur elektrischen Verbindung zwischen einem Rahmenschenkel und dem zugekehrten Verkleidungselement mindestens in einen Befestigungsdurchbruch der Profilseite ein U-förmiges Federelement so weit einsetzbar ist, daß dieses sich mit Haltekrallen des einen Schenkels an der Wandung des Befestigungsdurchbruches der Profilseite und mit Endkrallen des anderen Schenkels auf der zugekehrten Seite des Verkleidungselementes unter Federspannung abstützt.

Dieses Federelement kann in jeden beliebigen Befestigungsdurchbruch der Profilseite eines Rahmenschenkels eingesteckt werden, wobei die Haltekrallen des einen Schenkels sich im Befestigungsdurchbruch verspannen und einen elektrischen Kontakt zum Rahmenschenkel herstellen. Die Endkrallen des anderen Schenkels stützen sich am Verkleidungselement federnd ab. Die Haltekrallen und die Endkrallen durchdringen die Lackschicht und stellen eine eindeutige elektrische Verbindung zwischen dem Rahmenschenkel und dem Verkleidungselement her. Da beide Schenkel des Federelementes eine Federspannung erzeugen, wird eine ausreichende Kraft zum Durchstoßen der Lackschicht erzeugt.

Ist nach einer Ausgestaltung vorgesehen, daß das U-förmige Federelement eine Schenkelbreite aufweist, die an die parallel zum Verkleidungselement ausgerichtete Abmessung des Befestigungsdurchbruches abgestimmt ist, und daß das U-förmige Federelement mit dem Mittelschenkel voraus in den Befestigungsdurchbruch einsetzbar ist, dann kann sich das Federelement in dieser Richtung im Befestigungsdurchbruch nicht verschieben.

Damit das eingesteckte Federelement eine definierte Montagestellung einnimmt, ist nach einer Ausgestaltung vorgesehen, daß die Schenkel des U-förmigen Federelementes zu den freien Enden hin abgewinkelte Endabschnitte aufweisen, die breiter sind und Anschläge zur Begrenzung der Einsteckbewegung des Federelementes in den Befestigungsdurchbruch der Profilseite bilden.

Die Abwinkelungen der Schenkel des Federelementes sind nach einer Ausgestaltung so ausgeführt, daß der mit den Haltekrallen versehene Schenkel des Federelementes in der Einsteckstellung mit seinem Endabschnitt etwa senkrecht zur Profilseite steht, und daß der Endabschnitt des anderen Schenkels noch einmal abgewinkelt ist und mit einem stirnseitig mit den Endkrallen versehenen Abschnitt etwa senkrecht zum zugekehrten Verkleidungselement steht.

Ist vorgesehen, daß die Profilseite Teil einer mit dem Rahmenschenkel verbundenen Gleitschiene ist, die in einen senkrecht dazu stehenden Auflageabschnitt übergeht, auf der ein als Bodenplatte ausgebildetes Verkleidungselement direkt oder über ein Dichtungselement aufliegt, dann kann auf ebenso einfache Weise auch eine Bodenplatte des Schaltschrankes elektrisch leitend mit dem Rahmengestell verbunden werden. Die Ausbildung des Federelementes ist dabei vorzugsweise so, daß der Abstand der Schenkel des Federelementes kleiner ist als die senkrecht zu dem Verkleidungselement ausgerichtete Abmessung des Befestigungsdurchbruches.

Das Lösen des Federelementes aus der Montagestellung erfolgt durch einfachen Fingerdruck auf den Endabschnitt des einen Schenkels mit den Haltekrallen. Dieser kann auch einen Durchbruch als Schraubendreheraufnahme aufweisen.

Die Anordnung der Haltekrallen an dem einen Schenkel des Federelementes ist vorzugsweise so, daß die Haltekrallen zu beiden Schmalseiten des einen Schenkels ausgeformt sind. Die Haltekrallen verspannen sich dann an einander gegenüberliegenden Wänden des Befestigungsdurchbruches.

Die elektrische Verbindung zwischen dem Rahmengestell und dem Verkleidungselement über das Federelement läßt sich dadurch noch verbessern, daß die Anschläge der Schenkel als Krallen ausgebildet sind.

Die Erfindung wird anhand von in den Zeichnungen dargestellten Ausführungsbeispielen näher erläutert. Es zeigen:
- Fig. 1: in perspektivischer Ansicht ein U-förmiges Federelement zur Verbindung eines Verkleidungselementes mit dem zugekehrten Rahmenschenkel eines Rahmengestelles eines Schaltschrankes,
- Fig. 2: eine Teilansicht eines Schaltschrankes mit der elektrischen Verbindung einer Seitenwand und einer Bodenplatte mit dem Rahmengestell,
- Fig. 3: einen Schnitt durch die Verbindungsstelle zwischen Bodenplatte und Gleitschiene,
- Fig. 4: die Verbindungsstelle nach Fig. 3, jedoch unter Zwischenlage eines Dichtungselementes,
- Fig. 5: einen Teilschnitt, der eine andere Anformung des Federelementes erkennen läßt, das sich besonders für verbesserten Halt am Rahmenschenkel und für einen Toleranzausgleich im Abstand zwischen Rahmenschenkel und Verkleidungselement eignet, und
- Fig. 6: in zwei Ansichten das in Fig. 5 verwendete Federelement.

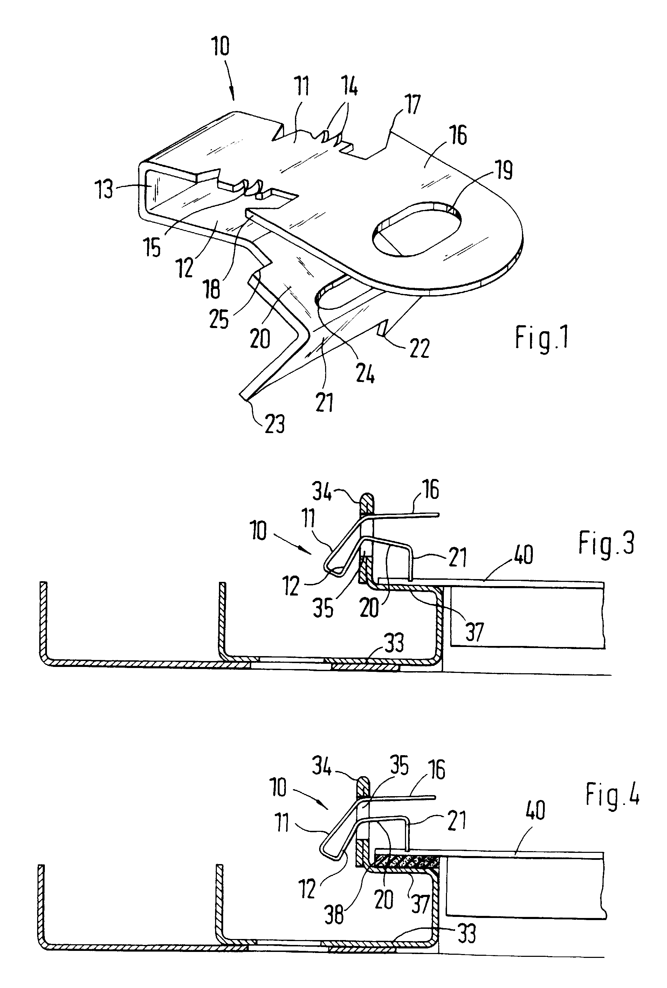

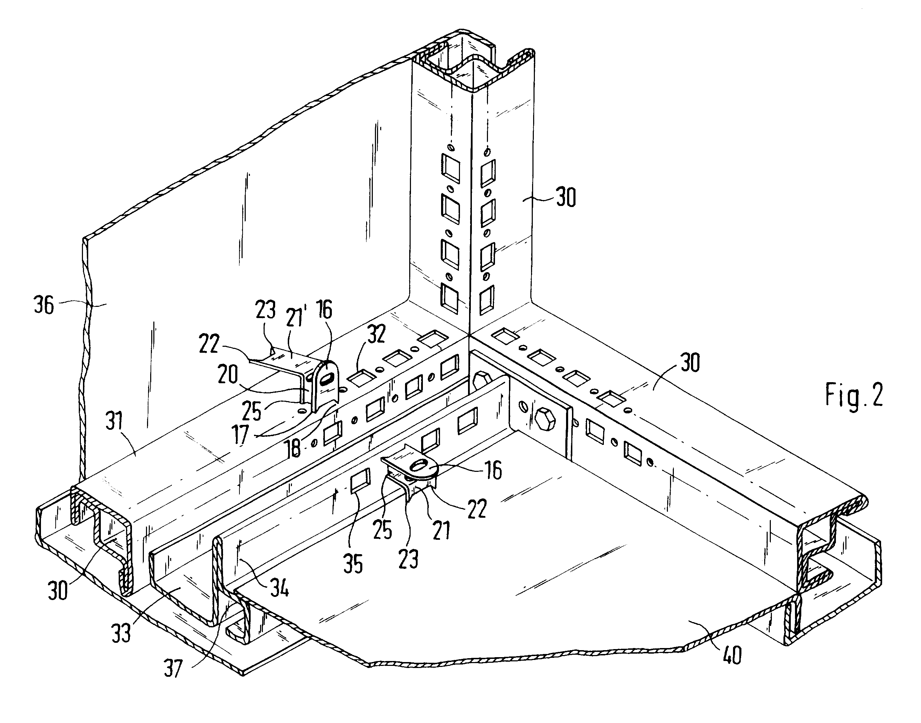

Wie die Fig. 1 zeigt, ist ein aus Federband bestehendes Federelement 10 U-förmig mit den beiden Schenkeln 11 und 12 und dem Mittelschenkel 13 gebogen. Die Breite der Schenkel 11 und 12 ist an die Abmessung von quadratischen Befestigungsdurchbrüchen in einer Profilseite des Rahmenschenkels des Rahmengestelles angepaßt. Der Abstand der Schenkel 11 und 12 ist kleiner als die Abmessung des Befestigungsdurchbruches, wie noch gezeigt wird.

Der eine Schenkel 11 geht in einen abgewinkelten Endabschnitt 16 über, der breiter ist und als Krallen ausgebildete Anschläge 17 und 18 bildet. Außerdem kann der Endabschnitt 16 mit einem Durchbruch 19 zum Einführen eines Schraubendrehers versehen sein, wie auch der verbreiterte Endabschnitt 20 des anderen Schenkels 12. Auch diese Übergänge können als Krallen ausgebildete Anschläge 25 bilden. Im Endbereich des Schenkels 11, d.h. kurz vor den Krallen-Anschlägen 17 und 18, sind an den Schmalseiten ein oder mehrere Haltekrallen 14 und 15 ausgeformt, die seitlich über die Schmalseiten und/oder die Außenseite des einen Schenkels 11 vorstehen und sich beim Einsetzen des Federelementes 10 in einen Befestigungsdurchbruch des Rahmenschenkels an den zugekehrten Wänden des Befestigungsdurchbruches verspannen und die aufgebrachte Lackschicht durchdringen. Der Endabschnitt 20 des Schenkels 12 ist noch einmal abgewinkelt, wie der in Endkrallen 22 und 23 auslaufende Abschnitt 21 zeigt.

Wie Fig. 2 zeigt, wird das Federelement 10 mit dem Mittelschenkel 13 voraus in einen Befestigungsdurchbruch 32 in einer mit einer Reihe von Befestigungsdurchbrüchen versehenen Profilseite 31 eines Rahmenschenkels 30 des Rahmengestelles eingesteckt, bis die Anschläge 17, 18 und 25 der Schenkel 11 und 12 an der Profilseite 31 anstoßen. Die Profilseite 31 des Rahmenschenkels 30 steht senkrecht zu dem anzubringenden Verkleidungselement 36, das im Ausführungsbeispiel eine Seitenwand ist. Der Abschnitt 21' ist so bemessen, daß sich die Endkrallen 22 und 23 unter Federspannung an der zugekehrten Innenseite des Verkleidungselementes 36 abstützen. Die seitlichen Haltekrallen 14 und 15 werden innerhalb des Befestigungsdurchbruches 32 verspannt.

Die Abwinkelungen der Schenkel 11 und 12 mit ihren Endabschnitten 16 und 20 bzw. 21 sind so, daß in der Montagestellung der Endabschnitt 16 etwa senkrecht zur Profilseite 31 und der Abschnitt 21 mit den Endkrallen 22 und 23 senkrecht zum Verkleidungselement 36 steht.

In gleicher Weise wird eine Bodenplatte 40 mit einer Gleitschiene 33 elektrisch leitend verbunden. Die Gleitschiene 33 ist mit einem Rahmenschenkel 30 verbunden und eine senkrecht ausgerichtete Profilseite 34 mit einer Reihe von Befestigungsdurchbrüchen 35 bildet einen Führungssteg zum Einschieben einer nicht dargestellten Montageplatte. Die Gleitschiene 33 weist einen senkrecht zur Profilseite 34 ausgerichteten Auflageabschnitt 37 auf, auf dem ein als Bodenplatte ausgebildetes Verkleidungselement 40 mit oder ohne Dichtungselement 38 aufgelegt wird, wie die Fig. 3 und 4 zeigen. Das in den Befestigungsdurchbruch 35 der Profilseite 34 eingesetzte Federelement 10 kann sich an die unterschiedliche Dicke des Verkleidungselementes 40 (Fig. 3) und der zusammengesetzten Dicke von Verkleidungselement 40 und Dichtungselement 38 (Fig. 4) anpassen und zwar durch Verringerung des Abstandes der Schenkel 11 und 12 bzw. ihrer Endabschnitte 16 und 20, 21, ohne dabei die Funktion der Haltekrallen 14 und 15 sowie der Endkrallen 22 und 23 zu beeinträchtigen. Bei der Kontaktierung des als Bodenplatte ausgebildeten Verkleidungselementes 40 ist der Abschnitt 21 des Federelementes 10 an den kleineren Abstand zwischen dem Befestigungsdurchbruch 35 und des als Bodenplatte ausgebildeten Verkleidungselementes 40 angepaßt.

Wie der Fig. 2 zu entnehmen ist, stützen sich die als Krallen ausgebildeten Anschläge 17 und 18 des Schenkels 11 und die als Krallen ausgebildeten Anschläge 25 des Schenkels 12 an der Profilseite 31 bzw. 34 federnd ab und verbessern dabei die elektrische Verbindung.

Wie in den Fig. 3 und 4 angedeutet ist, können am Schenkel 11 auch Krallen ausgestanzt und ausgebogen sein, die sich an der dem Verkleidungselement 40 abgekehrten, parallelen Wand des Befestigungsdurchbruches 35 federnd abstützen und für die Kontaktierung sorgen.

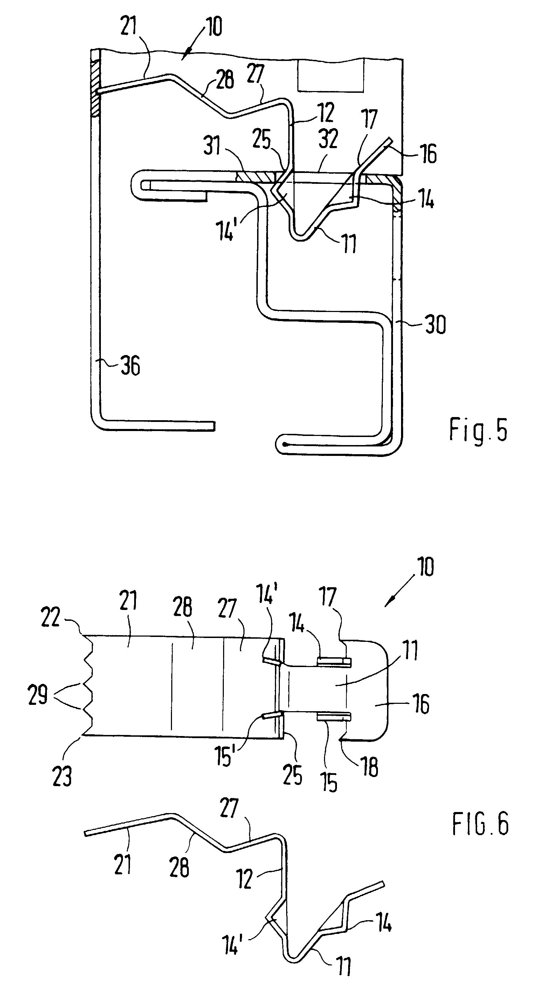

In Fig. 5 ist in einer Teilansicht mit Teilschnitt eine Kontaktierung eines Verkleidungselementes 36 mit einem Rahmenschenkel 30 nach Fig. 2 mit einem verbesserten Federelement 10 gezeigt. Dabei stehen die beiden Schenkel 11 und 12, die in den Durchbruch 32 der Profilseite 31 des Rahmenschenkels 30 bis zum Anschlag der als Krallen ausgebildeten Anschläge 17 und 18 am Übergang des einen Schenkels 11 zum breiteren Endabschnitt 16 und der als Krallen ausgebildeten Anschläge 25 am breiteren Endabschnitt 21 des anderen Schenkels 12 an der Außenseite der Profilseite 31 eingesteckt werden, in einem spitzen Winkel zueinander. Die Schenkel 11 und 12 sind an die Abmessung des Durchbruches 32 angepaßt und tragen beide an ihren Schmalseiten über die Schmalseiten und/oder die Außenseiten der Schenkel 11 und 12 vorstehende Haltekrallen 14 und 15 bzw. 14' und 15'. Diese Haltekrallen 14 und 15 bzw. 14' und 15' stehen schräg, wie insbesondere aus der unteren Seitenansicht der Fig. 6 zu entnehmen ist. Sie sind etwa dreieckförmig ausgebildet und können die zugekehrten Seiten des Durchbruches 32 nach dem Einrasten der Schenkel 11 und 12 teilweise hintergreifen und so den Halt des Federelementes 10 im Durchbruch 32 verbessern. Im Anschluß an die Haltekrallen 14' und 15' des Schenkels 12 verbreitert der Schenkel 12 sich und bildet als Krallen wirkende Anschläge 25, die sich auf der Profilseite 31 des Rahmenschenkels 30 abstützen und die Lackschicht durchdringen.

Der verbreiterte Schenkel 12 geht direkt in den Abschnitt 21 über, der in den am Verkleidungselement 36 abgestützten Endkrallen 22 und 23 endet. Um eine bessere Kontaktgabe zu erreichen, ist der Endabschnitt zwischen den Endkrallen 22 und 23 sägezahnartig ausgebildet, wie mit dem Bezugszeichen 29 angegeben ist. Damit die Abstützung am Verkleidungselement 36 selbst federnd ist und Toleranzen im Abstand zwischen dem Rahmenschenkel 30 und dem Verkleidungselement 36 ausgleichen zu können, wird der Endabschnitt 21 selbst Z-förmig abgekantet, so daß er in sich federn kann, wie mit den Abwinkelungen 27 und 28 gezeigt ist. Damit wird selbst bei Toleranzausgleich noch ein ausreichender Druck zwischen dem Endabschnitt 21 und dem Verkleidungselement 36 erzeugt, der in jedem Fall zum Durchstoßen der Lackschicht und Herstellen einer eindeutigen Kontaktierung ausreicht.

## Patentansprüche

1. Schaltschrank mit einem aus einzelnen Rahmenschenkeln zusammengesetzten und/oder aus an Verkleidungselementen abgekanteten Rahmenschenkeln gebildeten Rahmengestell, dessen offene Seiten mit Verkleidungselementen und einer Schranktür verschlossen oder verschließbar sind, bei dem die Rahmenschenkel und die Verkleidungselemente lackiert sind und bei dem die Rahmenschenkel mindestens eine mit einer Reihe von quadratischen oder rechteckförmigen Befestigungsdurchbrüchen versehene Profilseite aufweisen, die senkrecht zum zugekehrten Verkleidungselement ausgerichtet ist,
dadurch gekennzeichnet,
daß zur elektrischen Verbindung zwischen einem Rahmenschenkel (30,33) und dem zugekehrten Verkleidungselement (36,40) mindestens in einen Befestigungsdurchbruch (32,35) der Profilseite (31,34) ein U-förmiges Federelement (10) so weit einsetzbar ist, daß dieses sich mit Haltekrallen (14,15) des einen Schenkels (11) an der Wandung des Befestigungsdurchbruches (32,35) der Profilseite (31,34) und mit Endkrallen (22,23) des anderen Schenkels (12) auf der zugekehrten Seite des Verkleidungselementes (36,40) unter Federspannung abstützt.

2. Schaltschrank nach Anspruch 1,
dadurch gekennzeichnet,
daß das U-förmige Federelement (10) eine Schenkelbreite aufweist, die an die parallel zum Verkleidungselement (36,40) ausgerichtete Abmessung des Befestigungsdurchbruches (32,35) abgestimmt ist, und daß das U-förmige Federelement (10) mit dem Mittelschenkel (13) voraus in den Befestigungsdurchbruch (32,35) einsetzbar ist.

3. Schaltschrank nach Anspruch 1 oder 2,
dadurch gekennzeichnet,
daß die Schenkel (11,12) des U-förmigen Federelementes (10) zu den freien Enden hin abgewinkelte Endabschnitte (16, 20, 21) aufweisen, die breiter sind und Anschläge (17,18, 25) zur Begrenzung der Einsteckbewegung des Federelementes (10) in den Befestigungsdurchbruch (32,35) der Profilseite (31,34) bilden.

4. Schaltschrank nach einem der Ansprüche 1 bis 3,
dadurch gekennzeichnet,
daß der mit den Haltekrallen (14,15) versehene Schenkel (11) des Federelementes (10) in der Einsteckstellung mit seinem Endabschnitt (16) etwa senkrecht zur Profilseite (31,34) steht, und daß der Endabschnitt (20) des anderen Schenkels (12) noch einmal abgewinkelt ist und mit einem stirnseitig mit den Endkrallen (22,23) versehenen Abschnitt (21), der auch sägezahnartig ausgebildet sein kann, etwa senkrecht zum zugekehrten Verkleidungselement (36,40) steht.

5. Schaltschrank nach einem der Ansprüche 1 bis 4,
dadurch gekennzeichnet,
daß die Profilseite (34) Teil einer mit dem Rahmenschenkel (30) verbundenen Gleitschiene (33) ist, die in einen senkrecht dazu stehenden Auflageabschnitt (37) übergeht, auf der ein als Bodenplatte ausgebildetes Verkleidungselement (40) direkt oder über ein Dichtungselement (38) aufliegt.

6. Schaltschrank nach einem der Ansprüche 1 bis 5,
dadurch gekennzeichnet,
daß zumindest der Endabschnitt (16) des einen Schenkels (11) mit den Haltekrallen (14,15) einen Durchbruch (19) als Schraubendreheraufnahme aufweist.

7. Schaltschrank nach Anspruch 5,
dadurch gekennzeichnet,
daß der Abstand der Schenkel (11,12) des Federelementes (10) kleiner ist als die senkrecht zu dem Verkleidungselement (36,40) ausgerichtete Abmessung des Befestigungsdurchbruches (31,35).

8. Schaltschrank nach einem der Ansprüche 1 bis 7,
dadurch gekennzeichnet,
daß die Haltekrallen (14,15) zu beiden Schmalseiten des einen Schenkels (11) ausgeformt sind und seitlich über die Schmalseiten und/oder über die Außenseite des einen Schenkels (11) vorstehen.

9. Schaltschrank nach einem der Ansprüche 3 bis 8,
dadurch gekennzeichnet,
daß die Anschläge (17, 18) der Schenkel (11, 12) als Krallen ausgebildet sind.

10. Schaltschrank nach Anspruch 1, 8 oder 9,
dadurch gekennzeichnet,
daß die beiden Schenkel (11,12) des Federelementes (10) in einem spitzen Winkel zueinander stehen,
daß die seitlich über die Schmalseiten und/oder die Außenseite des einen Schenkels (11) vorstehenden Haltekrallen (14,15) etwa dreieckförmig ausgebildet sind und den Durchbruch (32) in der Profilseite (31) des Rahmenschenkels (30) teilweise hintergreifen und
daß auch der andere Schenkel (12) mit seitlich über die Schmalseiten und/oder über die Außenseite des anderen Schenkels (12) vorstehenden Haltekrallen (14', 15') versehen ist, die den Durchbruch (32) in der Profilseite (31) des Rahmenschenkels (30) auf der gegenüberliegenden Durchbruchseite teilweise hintergreifen.

11. Schaltschrank nach einem der Ansprüche 1 bis 4,
dadurch gekennzeichnet,
daß der andere Schenkel (12) direkt in den mit Endkrallen (22,23) versehenen Abschnitt (21) übergeht und selbst etwa Z-förmig (27,28) abgewinkelt ist und so federnd an der zugekehrten Seite des Verkleidungselementes (36) abstützt.

12. Schaltschrank nach einem der Ansprüche 1 bis 11,
dadurch gekennzeichnet,
daß der andere Schenkel (12) im Bereich zwischen den Endkrallen (22,23) sägezahnartig (29) ausgebildet ist.

## Claims

1. Switchgear cabinet, including a framework, which comprises individual frame members and/or is formed from frame members angled on cover members, the open sides of said framework being closed or closable by means of cover members and a cabinet door, wherein the frame members and the cover members are lacquered, and wherein the frame members have at least one section side, which is provided with a row of quadrilateral or rectangular securement openings and is aligned perpendicularly relative to the facing cover member, characterised in that, for the electrical connection between a frame member (30,33) and the facing cover member (36,40), a U-shaped resilient member (10) is insertable in at least one securement opening (32,35) of the section side (31,34) to such an extent that said resilient member is supported by retaining claws (14,15) of one part (11) on the wall of the securement opening (32,35) of the section side (31,34) and by end claws (22,23) of the other part (12) on the facing side of the cover member (36,40) under resilient tension.

2. Switchgear cabinet according to claim 1, characterised in that the U-shaped resilient member (10) has a part width which is adapted to the dimension of the securement opening (32,35) aligned parallel to the cover member (36,40), and in that the U-shaped resilient member (10), provided with the central part (13), is insertable in advance in the securement opening (32,35).

3. Switchgear cabinet according to claim 1 or 2, characterised in that the parts (11,12) of the U-shaped resilient member (10) have end portions (16,20,21), which are angled towards the free ends and are wider and form stop members (17,18,25) to define the insert movement of the resilient member (10) into the securement opening (32,35) of the section side (31,34).

4. Switchgear cabinet according to one of claims 1 to 3, characterised in that, in the inserted position, the part (11) of the resilient member (10) provided with the retaining claws (14,15) lies with its end portion (16) substantially perpendicularly relative to the section side (31,34), and in that the end portion (20) of the other part (12) is angled again and lies substantially perpendicularly relative to the facing cover member (36,40) with a portion (21) which is provided with the end claws (22,23) on its end face and may also have a sawtooth-like configuration.

5. Switchgear cabinet according to one of claims 1 to 4, characterised in that the section side (34) is part of a guide rail (33), which is connected to the frame member (30) and extends into a supporting portion (37), which lies perpendicularly thereto, and on which a cover member (40), which is configured as a base plate, lies directly on or above a sealing member (38).

6. Switchgear cabinet according to one of claims 1 to 5, characterised in that at least the end portion (16) of one part (11) provided with the retaining claws (14,15) has an opening (19) as the screwdriver receiving means.

7. Switchgear cabinet according claim 5, characterised in that the spacing between the parts (11,12) of the resilient member (10) is smaller than the dimension of the securement opening (31,35) orientated perpendicularly relative to the cover member (36,40).

8. Switchgear cabinet according to one of claims 1 to 7, characterised in that the retaining claws (14,15) are moulded on both narrow sides of one part (11) and protrude laterally beyond the narrow sides and/or beyond the external side of one part (11).

9. Switchgear cabinet according to one of claims 3 to 8, characterised in that the stop members (17,18) of the parts (11,12) are configured as claws.

10. Switchgear cabinet according to claim 1, 8 or 9, characterised in that the two parts (11,12) of the resilient member (10) lie at an acute angle relative to each other, in that the retaining claws (14,15), which protrude laterally beyond the narrow sides and/or the external side of one part (11), have a substantially triangular configuration and partially engage behind the opening (32) in the section side (31) of the frame member (30), and in that the other part (12) is also provided with retaining claws (14',15'), which protrude laterally beyond the narrow sides and/or beyond the external side of the other part (12) and partially engage behind the opening (32) in the section side (31) of the frame member (30) on the oppositely situated side of the opening.

11. Switchgear cabinet according to one of claims 1 to 4, characterised in that the other part (12) extends directly into the portion (21), which is provided with end claws (22,23), and itself has a substantially Z-shaped angular portion (27,28) and is thus resiliently supported on the facing side of the cover member (36).

12. Switchgear cabinet according to one of claims 1 to 11, characterised in that the other part (12) in the region between the end claws (22,23) has a sawtooth-like configuration (29).

## Revendications

1. Armoire électrique avec une structure constituée de branches individuelles et/ou de branches formées par cintrage d'éléments d'habillage, armoire dont les côtés ouverts sont ou peuvent être fermés par des éléments d'habillage et par une porte, armoire dont les branches d'encadrement et les éléments d'habillage sont laqués et dont les branches d'encadrement comportent au moins une aile de profilé présentant des percements de fixation de forme carrée ou rectangulaire, aile de profilé qui est orientée perpendiculairement à l'élément d'habillage qui lui fait face,
caractérisée en ce qu'aux fins d'établir la connexion électrique entre une branche d'encadrement (30, 33) et l'élément d'habillage (36, 40) qui lui fait face, un élément à ressort en forme de U (10) peut être enfiché dans au moins dans un percement de fixation (32, 35) de l'aile de profilé à une profondeur telle que cet élément à ressort (10) s'applique par des griffes de retenue (14, 15) d'une aile (11) du U contre 1' paroi eu percement de fixation (32, 35) de l'aile de profilé (31, 34) et s'applique avec contrainte élastique par des griffes terminales (22, 23) de l'autre aile (12) du U sur le côté qui lui fait face de l'élément d'habillage (36, 40).

2. Armoire électrique suivant la revendication 1,
caractérisée
en ce que l'élément élastique (10) présente une largeur d'aile qui est harmonisée avec la dimension orientée parallèlement à l'élément d'habillage (36, 40) du percement de fixation (32, 35), et
en ce que l'élément élastique en forme de U (10) peut être enfiché dans le percement de fixation (32, 35) par son aile médiane (13).

3. Armoire électrique suivant la revendication 1 ou 2,
caractérisée
en ce que les ailes (11, 12) de l'élément élastique en forme de U présentent des tronçons terminaux (16, 29, 21) coudés en larges et constituent des butées (17, 18, 25) pour limiter la course d'enfichage de l'élément élastique (10) dans le percement de fixation (32, 35) de l'aile du profilé (31, 34).

4. Armoire électrique suivant l'une quelconque des revendications de 1 à 3,
caractérisée
en ce que l'aile (11) de l'élément élastique (10), dotée des griffes de retenue (14, 15) est, dans la position d'enfichage, par son tronçon terminal (16) orientée sensiblement perpendiculairement à l'aile de profilé (31, 34), et
en ce que le tronçon terminal (20) de l'autre aile (12) est une nouvelle fois coudée et est, par son tronçon (21) doté des griffes terminales (22, 23), tronçon qui peut également être en forme de dents de scie, orienté sensiblement perpendiculairement à l'élément d'affichage (36, 40) qui lui fait face.

5. Armoire électrique suivant l'une quelconque des revendications de 1 à 4,
caractérisée
en ce que l'aile de profilé (34) fait partie d'un rail d'un rail de glissement (33) relié à la branche d'encadrement (30), rail qui se prolonge par un tronçon d'appui (37) qui lui est perpendiculaire, tronçon sur lequel est appliqué directement ou par l'intermédiaire d'un élément d'étanchéité un élément d'habillage (40) en forme de plaque de base.

6. Armoire électrique suivant l'une quelconque des revendications de 1 à 5,
caractérisée
en ce qu'au moins le tronçon terminal (16) d'une aile (11) avec les griffes de retenue (14, 15) présente un percement (19) faisant fonction de récepteur pour tournevis.

7. Armoire électrique suivant la revendication 5,
caractérisée
en ce que la distance entre les ailes (11, 12) de l'élément élastique (10) est inférieure à la dimension du percement de élastique (10) est inférieure à la dimension du percement de fixation (31, 35) qui est orientée perpendiculairement à l'élément d'habillage (36, 40).

8. Armoire électrique suivant l'une quelconque des revendications de 1 à 7,
caractérisée
en ce que les griffes de retenue (14, 15) sont formées sur les deux côtés étroits d'une (11) des ailes et font latéralement protubérance sur les côtés étroits et/ou sur le côté extérieur de cette aile (11).

9. Armoire électrique suivant l'une quelconque des revendications de 3 à 8,
caractérisée
en ce que l'autre aile (12) se prolonge directement par le tronçon (21) doté des griffes terminales (22, 23) et est elle-même coudée sensiblement en forme de Z (27, 28) et s'appuie de la sorte de manière élastique sur le côté qui lui fait face de l'élément d'habillage (36).

10. Armoire électrique suivant l'une quelconque des revendications 1, 8 ou 9,
caractérisée
en ce que les deux ailes (11, 12) de l'élément élastique forment entre elles un angle aigu,
en ce que les griffes de retenue (14, 15) faisant protubérance latéralement sur les côtés étroits et/ou le côté extérieur d'une (11) des ailes sont sensiblement de forme triangulaire et s'engagent partiellement derrière le percement (32) dans l'aile de profilé (31) de la branche d'encadrement (30) et
en ce que l'autre aile (12) également est dotée de griffes de retenue (14', 15') faisant protubérance latéralement sur les côtés étroits et/ou le côté extérieur de l'autre aile (12), griffes qui s'engagent partiellement derrière le percement (32) dans l'aile de profilé (31) de la branche d'encadrement (30) sur le côté opposé du percement.

11. Armoire électrique suivant l'une quelconque des revendications de 1 à 4.
caractérisée
en ce que l'autre aile (12) se prolonge directement par le tronçon (21) doté des griffes terminales (22, 23) et est elle-même coudée sensiblement en forme de Z ( 27, 28) et s'appuie ainsi élastiquement sur le côté qui lui fait face de l'élément d'habillage (36).

12. Armoire électrique suivant l'une quelconque des revendications de 1 à 11,
caractérisée
en ce que dans la région entre les griffes terminales (22, 23), l'autre aile est en forme de dents de scie (20).
